# EUROPEAN PATENT SPECIFICATION

(11) **EP 0 454 334 B1**
(45) Date of publication and mention of the grant of the patent: **02.01.1997**
(21) Application number: 91303326.2
(22) Date of filing: 16.04.1991
(51) Int. Cl.: G03F 7/039, C08L 33/06

(54) **Photoresist composition**
Photoresistzusammensetzung
Composition de photoréserves

(30) Priority: 24.04.1990 US 513741
(43) Date of publication of application: 30.10.1991
(73) Proprietor: International Business Machines Corporation, Armonk, N.Y. 10504 (US)
(72) Inventor: Allen, Robert David, San Jose, California 95120 (US); Hinsberg III, William Dinan, Fremont, California 94539 (US); Simpson, Logan Lloyd, Austin, Texas 78750 (US); Wallraff, Gregory Michael, San Jose, California 95123 (US)
(74) Representative: Burt, Roger James, Dr.

(56) References cited:
- EP-A- 0 062 474
- US-A- 4 371 605
- US-A- 4 491 628
- US-A- 4 629 680

## Description

The present invention relates generally to photoresist compositions and more particularly to such compositions for use in the production of printed circuits.

As printed circuits become smaller and/or more densely packaged, need for higher resolution is a continuing driving force in the development of new lithographic materials. The "RISTON" family of dry film photoresists are widely utilized in circuit board fabrication. These materials are based on photoinitiated free-radical polymerization of multifunctional monomers, leading to insolubilization of the exposed areas via cross-linking. Such resists exhibit high sensitivity due to the nature of the polymerization wherein many covalent bonds are produced for each radical generated. However, the tendency toward swelling during development, the requirement for an oxygen impermeable cover sheet during the exposure step, and resolution limitations are all drawbacks which are intrinsic to this resist chemistry.

Resist systems based on acid-catalyzed chain reactions (e.g., polymerization, depolymerization, side chain cleavage, etc.) have been proposed, for example, Polymers in Electronics, Davidson T. Ed., ACS Symposium Series 242, American Chemical Society, Washington, D.C., 1984, p.11, H. Ito, C.G. Willson. These system offer high sensitivity due to a mechanism known as amplification while avoiding many of the drawbacks of free-radical based systems.

We have found that a particular family of photoresist compositions exploiting the mechanism of acid-catalyzed chemical amplification offers marked advantages in printed circuit board manufacture, not only in terms of resolution, but also in their the capability of imaging at a selected wavelength, thermal properties for liquid-appliable applications, and their aqueous processibility.

US Patent 4,629,680 discloses a binder derived from monomer units. This binder is however used together with ethylenically unsaturated compounds to form a photopolymerizable composition. It does not disclose the use of this binder polymer together with photoacid generators.

According to the invention we provide a photoresist composition which is processable in aqueous media
(A) a film forming terpolymer binder, the polymer chain of said polymer binder comprising the following terpolymerizable units:
   a first monomer which contributes acid sensitive groups pendant on the polymer backbone,
   a second monomer selected from the group consisting of alkyl methacrylates, alkyl acrylates and combinations thereof,
   a third monomer selected from the group consisting of carboxylic acids of acrylates and carboxylic acids of methacrylates,and
(B) an initiator which generates acid upon exposure to radiation.

The first monomer is preferably a tertiary butyl ester of a carboxylic acid. The second monomer is preferably methyl methacrylate and the third monomer is preferably methacrylic acid.

### DETAILED DESCRIPTION OF THE PREFERRED EMBODIMENT

The photoresist compositions of the invention include a film forming polymer binder. The binder is an acrylic polymer which includes acid-labile side groups which react with a selected photoacid generator in a chemical amplification reaction to produce positive photoresists.

The acrylic polymer which makes up the film forming binder includes a first monomer which contributes the acid sensitive groups pendant on the polymer backbone. The preferred acid labile pendant groups are t-butyl esters of carboxylic acids and t-butyl carbonates of phenols but, it is understood that a wide range of acid labile groups are operative in the invention. For instance, additional acid sensitive groups are listed in U.S. Patent No. 4,491,628, "Positive- And Negative-Working Resist Compositions With Acid Generating Photoinitiator and Polymer With Acid-Labile Groups Pendant From Polymer Backbone". Preferred acid sensitive groups useful in the practice of the present invention include the t-butyl esters of acrylates and methacrylates.

The first monomer is preferably present in the polymer binder in the range from about 10 to 50% by weight based on the sum of all polymerizable units present.

The second class of monomer used to produce the polymeric binder is selected from the group consisting of alkyl methacrylates, alkyl acrylates and combinations thereof, e.g. methyl methacrylate (MMA) or ethyl methacrylate, ethyl acrylate or butyl acrylate. The most preferred second monomers are methyl methacrylate and/or ethyl acrylate. The choice of monomer or monomers which make up the second monomer class is dependent, at least in part, upon the glass temperature (Tg) requirement of the polymer binder which differs dependent upon whether the composition will be liquid or dry-film applied. The second monomer class is present in the polymer binder in the range of 30-70% by weight based on the sum of all polymerizable units present.

The third monomer is preferably selected from the group consisting of carboxylic acids of acrylates and carboxylic acids of methacrylates, e.g., acrylic acid and methacrylic acid. The choice of third monomer is also influenced by the glass temperature (Tg) requirements of the polymer binder. The third monomer is preferably present in the polymer in the range from about 5 to 30% by weight, based on the sum of all polymerized units present.

The preparation of polymers falling within the above described classes will be familiar to those skilled in the art, since they are readily prepared using known techniques. For instance, methacrylate and acrylate homo-,co-,ter-, tetra-, etc., polymers are synthesized by free radical solution polymerization. The choice of polymerization solvent is governed by factors such as solubility of the monomers, the nature of the initiators and formed polymer, boiling point, cost, etc. A variety of azo and peroxide initiators can be used to initiate the polymerization. In a typical synthesis, a reactor is charged with solvent (THF, MEK, etc.) and the desired monomers such that the formed polymer, assuming 100% conversion, attains a final concentration of 10 to 50% (wt/wt). The initiator is then charged (typically AIBN or BPO), at levels from 0.05% to 1.0% (vs. monomer), depending on the desired molecular weight. The system is sparged with nitrogen to remove oxygen. The polymerization is typically run at 60 to 80 degrees centigrade for 10 to 24 hours. The polymer is isolated by precipitation into a nonsolvent (hydrocarbon or water), and collected and dried at elevated temperatures under vacuum.

The initiator or photoacid generator used in the photosensitive resist compositions of the invention produce strong acids upon exposure to radiation. They are described in the literature and include, depending upon the exposure technology, aryldiazonium, diaryliodonium and triarylsulfonium metal halides. Other photoacid generators are described, e.g., in U.S. Patent No. 4,250,053, "Sensitized Aromatic Iodonium or Aromatic Sulfonium Salt Photoinitiator Systems". Nonionic photoacid generators are also well known and are described in the art. The photoacid generator is preferably present in the polymer binder in the range from about 1 to 20 w/w% to polymer.

The photoresist compositions of the invention can also contain a sensitizer capable of sensitizing the photoacid generator to longer wavelengths ranging from mid UV to visible light. Depending upon the intended application, such sensitizers include polycyclic aromatics such as pyrene and perylene. The sensitization of the photoacid generators is well known and has been described in United States Patent No. 4,250,053, cited earlier and in C. Rehner, United States Patent No. 4,371,605. A preferred sensitizer useful in sensitizing the photoresist compositions of the invention for visible light or laser direct imageable photoresists is described in our copending European Application Number 90313654.7. The invention is not limited to the use of a particular class of sensitizer or photoacid generator, however.

The film forming polymer binder and selected photoacid generator provide a photoresist composition which is well suited for use in imaging processes utilizing the imaging mechanism known as "chemical amplification." The methacrylate terpolymers used as the acid-labile binder provide tough, film-forming characteristics, while the "chemical amplification" mechanism (involving onium salt photolysis, acid generation, and side-group deprotection) is unique in its ability to afford a combination of high photospeed, high contrast, and oxygen insensitivity. Chemical amplification is described, e.g., in USP 4,491,628, previously cited.

The polymer materials selected from the first, second and third monomer classes described above, and which are used in the resists of the invention, have properties which make them uniquely suited as photoresists. The t-butyl ester monomer contributes the acid sensitive groups which form the basis of the acid catalyzed deprotection mechanism. The acrylate/methacrylate monomer increases the toughness of the film, while the acrylic acid/methacrylic acid monomer helps to control the development rate of the exposed resist. In the case of liquid-apply resists, a terpolymer of methyl methacrylate, t-butyl methacrylate, methacrylic acid provides advantages not present in the prior art. These terpolymers are tough, film-forming, and have high photospeeds due to the acid-catalyzed imaging mechanism. Due to the non-swelling nature and high contrast of these resists, they are capable of much higher resolution than existing photoresists used for circuit board manufacture.

Thus, the above stated monomers each fill a vital role in the makeup of the resin system. The t-butyl ester monomer (e.g. t-butyl methacrylate) (TBMA) imparts acid sensitivity to the polymer, i.e., photogenerated acid can react with side groups in the polymer chain to render them soluble in an aqueous base developer. However, a simple poly(t-butyl methacrylate) homopolymer is inadequate for circuitization applications, due to its cost, poor mechanical properties, incompatibility toward a variety of common acid generators. A much more desirable resin is produced through copolymerization with methyl methylacrylate and/or ethyl acrylate. Copolymerization with this "non-active" monomer leads to dramatic increase in mechanical properties and cost performance. In addition, the increase in solubility of most common photoinitiators in the polymer film leads to an unanticipated increase in photospeed. These copolymers are excellent imaging materials when formulated with photo-acid producing compounds. Their only limitation is the lack of processibility in fully aqueous developers (e.g. aqueous sodium carbonate). The addition of a third monomer is critical in achieving the desired developability. Methacrylic acid and/or acrylic acid is terpolymerized with the above two monomers. A compositional window exists whereby fairly rapid yet practical development rates in exposed areas exists, but the unexposed film exhibits no developer attack. It was anticipated that this addition of acidic monomer would lead to a loss of contrast, but within the boundaries of this relatively wide window, contrast is excellent. These terpolymers are synergistic materials which combine aqueous developability, good mechanical properties, low cost, excellent adhesion, and excellent contrast to lead to outstanding resolution capabilities.

These terpolymers exhibit excellent development characteristics, similar to those commonly fourd in high resolution novolak-based photoresists. An initial induction period, followed by a second stage of rapid development is common to both classes of materials, leading to high contrast, and thus, resolution.

The following example is intended to be illustrative of the invention:

### EXAMPLE

A preferred liquid apply photoresist was prepared by combining in cyclohexanone solution the product of terpolymerization of MMA, TBMA and MAA, of composition 44/40/16 (weight ratio) respectively, with the visible sensitizing composition described in the copending European Application Number 90313654.7 referenced earlier. The solution was applied to a copper substrate to give a film thickness of approximately 5 microns and was imaged with the Excellon visible laser direct-write tool and processed.

The tool was used to expose large pads at successively higher doses, followed by a 105°C postbake and a development step in 1.2% aqueous sodium carbonate. The minimum dose required to clear the resist to the substrate under the conditions used was 6 mJ/cm². The contrast, , the slope of the film thickness vs. log dose curve is greater than 10. Contrast is related to resolution, and the contrast of this resist is an order of magnitude higher than conventional materials (Riston: =0.8-1.2) . Although the particular resist employed a sensitizer package designed to sensitize the photoacid generator to utilize 514 nm light most efficiently, the resist shows excellent sensitivity to UV light. At doses of 15 mJ/cm², resolution of 1 mil was obtained with this resist. Resolution extendibility was demonstrated by printing 1.25 um lines/spaces on silicon substrates with a PE-500 projection printer, followed by aqueous carbonate development.

An invention has been provided with several advantages. The materials of the invention are tough, film-forming, capable of acid-catalyzed deprotection chemistry, high resolution imaging and are developable in sodium carbonate/water. Specially tailored properties can be "tuned" to an unanticipated extent by adjusting both the monomer ratios and molecular weight. Thus, TBMA provides the acid sensitivity which is the basis of a chemically amplified resist. The non-active monomer (MMA) gives improved mechanical properties and increases the solubility of the photoacid generator in the terpolymer binder without degrading the photospeed. A third monomer (MAA), acts to alter the development rate of the exposed resist, without affecting the contrast, i.e., the unexposed resist remains inert to the developer.

## Claims

1. A photoresist composition which is processable in aqueous media, comprising
(A) a film forming terpolymer binder, the polymer chain of said polymer binder comprising the following terpolymerizable units:
a first monomer which contributes acid sensitive groups pendant on the polymer backbone;
a second monomer selected from the group consisting of alkyl methacrylates, alkyl acrylates and combinations thereof;
a third monomer selected from the group consisting of carboxylic acids of acrylates and carboxylic acids of methacrylates, and
(B) an initiator which generates acid upon exposure to radiation.

2. A composition as claimed in claim 1, wherein
the first monomer is selected from the group consisting of tertiary butyl esters of carboxylic acids and tertiary butyl carbonates of phenols, and
the second monomer is an alkyl methacrylate.

3. A composition as claimed in claim 2, wherein
the first monomer is selected from the group consisting of tertiary butyl acrylate and tertiary butyl methacrylate.

4. A composition as claimed in any of claims 1 to 3, wherein the second monomer is methyl methacrylate.

5. A composition as claimed in any preceding claim, wherein the third monomer is selected from the group consisting of acrylic acid and methacrylic acid.

6. A photoresist composition is claimed in claim 4 and claim 5, wherein the terpolymer binder comprises approximately 10 to 50% by weight tertiary methacrylate, 30 to 70% by weight methyl methacrylate and 5 to 20% by weight methacrylic acid.

## Patentansprüche

1. Eine Photoresistzusammensetzung, die in einem wasserhaltigen Medium verarbeitet werden kann und folgendes umfaßt:
(A) ein filmbildendes Terpolymerbindemittel, wobei die Polymerkette des Polymerbindemittels folgende terpolymerisierbare Einheiten enthält:
ein erstes Monomer, das am Polymergerüst hängende säureempfindlichen Gruppen bereitstellt;
ein zweites Monomer aus der Gruppe, bestehend aus Alkylmethacrylaten, Alkylacrylaten und Zusammensetzungen davon;
ein drittes Monomer aus der Gruppe, bestehend aus Karbonsäuren von Acrylaten und Karbonsäuren von Methacrylaten, und
(B) ein Initiator, der eine Säure erzeugt, nachdem er Strahlung ausgesetzt wurde.

2. Eine Zusammensetzung nach Anspruch 1, bei der
das erste Monomer aus der Gruppe ausgewählt wird und aus tertiären Butylestern von Karbonsäuren und tertiären Butylcarbonaten von Phenolen besteht, und
das zweite Monomer ein Alkylmethacrylat ist.

3. Eine Zusammensetzung nach Anspruch 2, bei der
das erste Monomer aus der Gruppe ausgewählt wird und aus einem tertiären Butylacrylat und einem tertiären Butylmethacrylat besteht.

4. Eine Zusammensetzung nach einem der Ansprüche 1 bis 3, bei der das zweite Monomer ein Methylmethacrylat ist.

5. Eine Zusammensetzung nach einem der oben genannten Ansprüche, bei der das dritte Monomer aus der Gruppe ausgewählt wird und aus Acrylsäure und Methacrylsäure besteht.

6. Eine Photoresistzusammensetzung nach Anspruch 4 und Anspruch 5, bei der das Terpolymerbindemittel aus tertiärem Methacrylat mit einem gewichtsmäßigen Anteil von 10 bis 50%, Methylmethacrylat mit einem gewichtsmäßigen Anteil von 30 bis 70% und Methacrylsäure mit einem gewichtsmäßigen Anteil von 5 bis 20% besteht.

## Revendications

1. Une composition de photoréserve, destinée à être traitée dans des milieux aqueux, comprenant :
(A) un liant terpolymère filmogène, la chaîne polymère dudit liant polymère comprenant les unités terpolymérisables suivantes :
un premier monomère qui contribue aux groupes sensibles à l'acide dépendant de l'ossature polymère;
un deuxième monomère sélectionné dans le groupe composé des alkyle méthacrylates, alkyle acrylates et de leurs combinaisons;
un troisième monomère sélectionné dans le groupe composé des acides carboxyliques d'acrylates et les acides carboxyliques de méthacrylates, et
(B) un initiateur générant un acide lors de l'exposition à un rayonnement.

2. Une composition selon la revendication 1, dans laquelle :
le premier monomère est sélectionné dans le groupe constitué d'esters butyle tertiaires d'acides carboxyliques et de carbonates butyle tertiaires de phénols, et
le deuxième monomère est un alkyle méthacrylate.

3. Une composition selon la revendication 2, dans laquelle le premier monomère est sélectionné dans le groupe constitué de butyle acrylate tertiaire et de butyle méthacrylate tertiaire.

4. Une composition selon l'une quelconque des revendications 1 à 3, dans laquelle le deuxième monomère est du méthyle méthacrylate.

5. Une composition selon l'une quelconque des revendications précédentes, dans laquelle le troisième monomère est sélectionné dans le groupe constitué de l'acide acrylique et de l'acide méthacrylique.

6. Une composition selon la revendication 4 et la revendication 5 dans laquelle le liant terpolymère comprend environ 10 à 50 % en poids de méthacrylate tertiaire, 30 à 70 % en poids de méthyle méthacrylate et 5 à 20 % en poids d'acide méthacrylique.
